Europäisches Patentamt

European Patent Office

Office européen des brevets

(19)

(11) **EP 0 596 562 B1**

(12) **FASCICULE DE BREVET EUROPEEN**

(45) Date de publication et mention
de la délivrance du brevet:
**07.01.1999 Bulletin 1999/01**

(51) Int Cl.6: **H03F 1/30, H03F 3/193**

(21) Numéro de dépôt: **93203011.7**

(22) Date de dépôt: **28.10.1993**

(54) **Dispositif comprenant un circuit pour traiter un signal alternatif**

Vorrichtung mit einer Schaltung zum Verarbeiten eines Wechselsignals

Device comprising a circuit for processing an alternating signal

(84) Etats contractants désignés:
**DE FR GB**

(30) Priorité: **04.11.1992 FR 9213244**

(43) Date de publication de la demande:
**11.05.1994 Bulletin 1994/19**

(73) Titulaires:
- **LABORATOIRES D'ELECTRONIQUE PHILIPS S.A.S.**
  **94450 Limeil-Brévannes (FR)**
  Etats contractants désignés:
  **FR**
- **Koninklijke Philips Electronics N.V.**
  **5621 BA Eindhoven (NL)**
  Etats contractants désignés:
  **DE GB**

(72) Inventeur: **Masliah, Denis**
  **F-75008 Paris (FR)**

(74) Mandataire: **Lottin, Claudine et al**
  **Société Civile S.P.I.D.**
  **156, Boulevard Haussmann**
  **75008 Paris (FR)**

(56) Documents cités:
  **EP-A- 0 203 895**

- **IEEE TRANSACTIONS ON ELECTROMAGNETIC COMPATIBILITY vol. 16, no. 1 , Février 1974 , NEW YORK US pages 29 - 38 D.C. SURANA ET AL 'GAIN AND DISTORTION PROPERTIES OF FET MIXERS AND MODULATORS'**
- **PATENT ABSTRACTS OF JAPAN vol. 9, no. 31 (E-295)(1754) 9 Février 1985 & JP-A-59 174 007 (FUJITSU K.K.) 2 Octobre 1984**
- **PATENT ABSTRACTS OF JAPAN vol. 4, no. 165 (E-34)(647) 15 Novembre 1980 & JP-A-55 112 012 (NIPPON HOSO KYOKAI) 29 Août 1980**
- **PATENT ABSTRACTS OF JAPAN vol. 14, no. 297 (E-945)27 Juin 1990 & JP-A-02 094 908 (SHARP CORP) 5 Avril 1990**

**Description**

L'invention concerne un dispositif comprenant un circuit pour traiter un signal alternatif, ce circuit incluant un premier étage avec un premier élément actif polarisé par une première tension de polarisation appliquée entre sa première électrode principale, et sa seconde électrode principale, et par une seconde tension de polarisation appliquée entre son électrode de commande, et sa seconde électrode principale, cette électrode de commande recevant aussi le signal alternatif, cet élément actif étant du type dans lequel, en fonctionnement, normalement aucun courant de polarisation ne circule dans l'électrode de commande.

L'invention trouve particulièrement son application dans la réalisation de circuits semiconducteurs fonctionnant en hyperfréquences, pour le domaine des télécommunications, dans la gamme des systèmes portables et grand public.

Un étage amplificateur à transistor à effet de champ est déjà connu de l'état de la technique par le brevet US 5041796. Cet étage est destiné à former un amplificateur large bande.

A cet effet, la couche active du transistor à effet de champ amplificateur est modifiée par rapport à celle de transistors traditionnellement connus de l'homme du métier. Cette couche modifiée présente un profil de dopage selon lequel la concentration en porteurs est moins forte près de la surface du transistor, et plus forte lorque l'on s'éloigne de cette surface.

Le transistor précité est utilisé avec un montage de polarisation qui inclut une résistance RG de 10 kΩ disposée entre grille et masse du transistor, une résistance Rf de 300 Ω en série avec une capacité Cf de 50 pH disposée entre grille et drain, la charge étant constituée par une inductance placée entre le drain et l'alimentation continue positive de 3V, et la source du transistor étant reliée directement à la masse.

Ce transistor possède donc la propriété de montrer une transconductance constante, en fonction de la différence de potentiel grille-source : mais il n'est pas utilisé pour produire un potentiel continu de valeur différente de celle du potentiel de l'alimentation continue qui est +3V, ceci dans le but de polariser en continu plusieurs autres étages d'un circuit semiconducteur intégré avec cet étage amplificateur.

Or, à ce jour, un problème technique se pose lorsque l'on veut alimenter en continu les circuits semiconducteurs intégrés des petits systèmes portables, ou de tout système à vocation grand public et peu onéreux. Dans ces systèmes, il est souhaité de n'associer audit système, qu'une seule alimentation continue, par exemple au moyen de piles ou batteries de 3V, et de générer dans le circuit lui-même, une seconde alimentation continue négative, nécessaire au fonctionnement des étages à transistors à effet de champ.

Il est à ce jour connu de l'homme du métier, pour générer une tension continue négative à partir de la tension d'alimentation continue +3V, de prévoir un étage inverseur. Cet étage inverseur réalise un échantillonnage, en créant un signal alternatif à une fréquence élevée, d'amplitude comprise entre 0 et +3 V, de forme rectangulaire. A partir de ce signal haché, un second étage décaleur placé à la suite de l'étage inverseur, décale le signal alternatif d'amplitude 0 à 3 V, en faisant coïncider le niveau +3V avec une masse, ce qui met le niveau qui était précédemment à 0, à la tension - 3V. On crée ainsi, entre 0 et -3V un signal haché qui peut générer une tension continue négative de -3V. L'inconvénient est que ce signal haché à des flancs très raides, et qu'il fournit en fait tous les multiples de la fréquence d'échantillonnage. Ce qui fait qu'il est ensuite nécessaire, pour éliminer ces harmoniques très gênantes dans le fonctionnement en hautes et hyperfréquences, d'adjoindre à ce circuit générateur de tension négative, un filtre dont la réalisation est très sophistiquée, c'est-à-dire compliquée et coûteuse.

D'une manière générale, la génération, dans un circuit intégré hautes ou hyperfréquences d'une seconde tension de signe opposé à celui d'une première tension d'alimentation continue ou de valeur différente de celle de cette tension est un gros problème, et le nombre des circuits affectés par ce problème, est grand.

En effet, dans les circuits intégrés, il est très souvent nécessaire de disposer de deux tensions continues de signes opposés, pour polariser les transistors dans chaque étage du circuit. Dans le domaine particulier des circuits hyperfréquences, pour l'application en télécommunications, on voit apparaître de plus en plus de systèmes portables et grand public qui doivent en plus être compacts, c'est-à-dire réalisés avec un nombre aussi petit que possible d'éléments, très fiables, peu onéreux, et surtout simples, c'est-à-dire fonctionnant avec une seule pile (ou batterie) donc munis d'une seule entrée pour l'alimentation continue ; et néanmoins fonctionnant avec des performances aussi bonnes, sinon meilleures, que des circuits encombrants, sophistiqués et onéreux.

La présente invention propose une solution à ce problème au moyen du dispositif tel que défini dans le préambule et en outre caractérisé en ce que, la seconde tension de polarisation en continu $V_G$ est générée aux bornes d'une résistance R couplée à l'électrode de commande et à la seconde électrode principale, par l'application sur l'électrode de commande d'un signal alternatif de puissance suffisante pour mettre en oeuvre les propriétés rectificatrices de l'élément actif entre son électrode de commande et sa seconde électrode principale.

Ce dispositif présente l'avantage que l'on peut générer la seconde tension continue, avec un seul étage incluant un nombre restreint de composants ; de plus le filtre qu'il est souhaitable d'utiliser pour éliminer le signal alternatif aidant à générer la seconde tension continue négative, ne sera pas un filtre onéreux et sophistiqué, mais au contraire un filtre simple et bon marché.

Dans une mise en oeuvre, ce dispositif est caractérisé en ce que le générateur de signal alternatif de puissance pour appliquer sur l'électrode de commande de l'élément actif, est le générateur du signal alternatif de fonctionnement lui-même.

Dans ce cas, ce signal de fonctionnement appliqué à l'entrée du circuit lui-même sature l'élément actif de ce premier étage, alimenté par ladite première tension d'alimentation continue. Ce signal subit certes, ce faisant une transformation ; mais le signal de sortie de l'étage est parfait à la fréquence fondamentale, et seules les harmoniques sont gênantes ; cependant ces harmoniques ne sont pas dans la bande de fréquences de fonctionnement et elles seront éliminées par un filtrage ultérieur facile à réaliser.

Dans une variante de mise en oeuvre, ce dispositif est caractérisé en ce que le générateur de signal alternatif de puissance pour appliquer sur l'électrode de commande de l'élément actif, est un générateur auxiliaire.

L'avantage est dans ce cas également qu'un filtre simple et peu coûteux est ensuite utilisé pour éliminer le signal de la source auxiliaire qui, du fait de sa fréquence, est peu gênant.

Un autre avantage de cette variante de mise en oeuvre est que, dans ce cas, la puissance du signal à la fréquence de fonctionnement, peut être quelconque, et même variable. Au contraire, dans la première mise en oeuvre citée, le signal de fonctionnement doit avoir une puissance constante, l'avantage résidant dans ce dernier cas dans la simplicité de mise en oeuvre.

Dans tous les cas, les circuits sont simples et fiables, peu encombrants, peu coûteux, tout à fait compatibles avec les contraintes des dispositifs portables et grand public. Comme les harmoniques gênantes sont faciles à éliminer, les circuits seront de surcroît de meilleure qualité que les circuits connus.

L'invention est décrite ci-après en détail en référence avec les figures annexées, dont :

- la figure 1a représente schématiquement un étage dit de polarisation générateur d'une seconde tension continue de signe opposé à celui de sa tension d'alimentation, utilisant un signal alternatif auxiliaire, à une fréquence différente de la fréquence du signal alternatif de fonctionnement ;
- la figure 1b représente schématiquement un tel étage de polarisation, dans ce cas utilisant le signal alternatif de fonctionnement lui-même ;
- la figure 1c représente schématiquement un étage de polarisation générateur d'une seconde tension continue plus négative que sa tension de polarisation de source.
- la figure 2 représente respectivement en trait discontinu, sur la courbe A, la caractéristique $I_G$ en fonction de $V_{GS}$ d'un transistor de puissance non saturé, et en trait continu, sur la courbe B, la caractéristique $I_G$ en fonction de $V_{GS}$ d'un transistor de puissance saturé par un signal d'entrée alternatif ;
- la figure 3 représente un exemple de circuit alimenté en continu au moyen d'une alimentation continue positive extérieure et de la tension continue négative générée par un étage intégré de polarisation tel que décrit en référence avec une des figure 1.

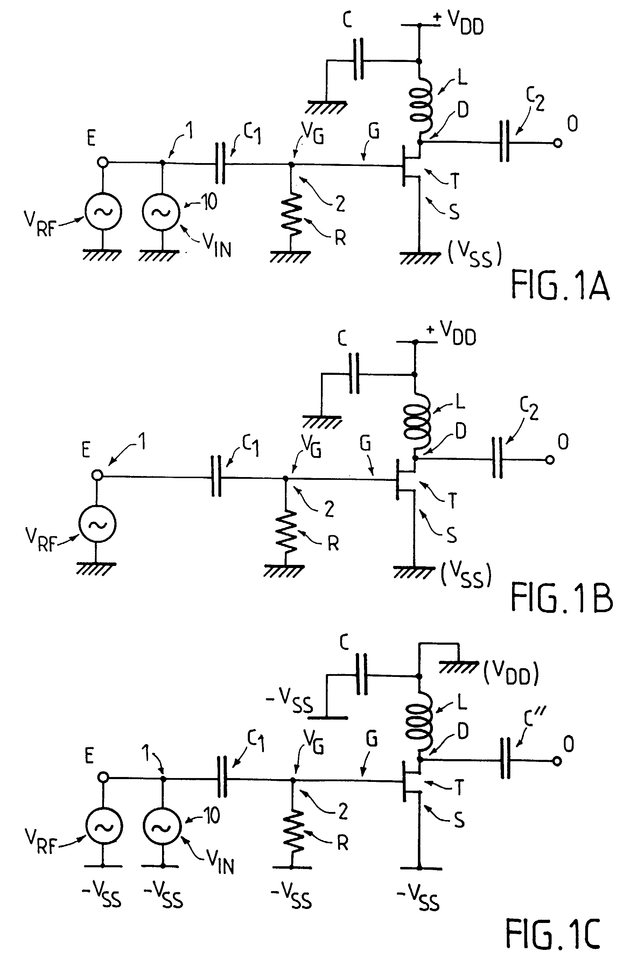

En référence avec l'une des figures 1a ou 1b, est décrit ci-après à titre d'exemple non limitatif, un circuit avec un premier étage dit de polarisation, générateur d'une tension continue négative, cet étage étant par ailleurs alimenté en continu au moyen d'une tension positive de +3 V, appliquée sur une première borne $V_{DD}$ et fournie par des moyens extérieurs au circuit.

Ce premier étage comprend un premier élément actif, par exemple un transistor T qui est fondamentalement un transistor de puissance. Ce transistor est lui-même polarisé vis-à-vis de l'alimention continue + $V_{DD}$ par une forte résistance R disposée entre sa grille G et une seconde borne $V_{SS}$ qui est ici la masse ; son drain D est relié à la borne $V_{DD}$, sur laquelle on trouve l'alimentation continue positive, à travers une charge L ; et sa source S est reliée directement à la seconde borne $V_{SS}$ de masse.

La charge L de drain peut être par exemple résistive. Mais de préférence, lorsque le circuit traite un signal haute ou hyperfréquences on utilisera comme charge une inductance L. Une telle charge inductive L présente l'avantage de ne pas créer de différence de potentiel entre le drain D et l'alimentation continue positive $V_{DD}$, de telle sorte que cette tension continue positive se retrouve entièrement sur le drain D du transistor. Avec une telle charge inductive, le drain D du transistor est donc aussi au potentiel continu +3V.

D'autre part, en fonctionnement alternatif, la charge L purement inductive isole la sortie du tansistor T, qui se fait sur le drain D au point 0.

Il en résulte donc que le transistor de puissance T peut développer une puissance plus grande que si le drain était à une tension continue moins grande (ce qui est le cas avec une charge résistive), puisqu'aux bornes du transistor T on trouve ces +3V non diminués.

Cet étage comprend éventuellement, en outre, une capacité C de découplage de l'alimentation continue $V_{DD}$, disposée entre cette ligne d'alimentation +$V_{DD}$ et la masse. Cette capacité est particulièrement utile lorsque la tension $V_{DD}$ continue positive +3V est amenée à l'étage en question au moyen d'un conducteur de grande longueur, c'est-à-dire lorsque les moyens fournissant l'alimentation +3V sont éloignés de cet étage. Cette capacité permet alors de mieux réaliser le court-circuit de la charge inductive L dans le fonctionnement en alternatif.

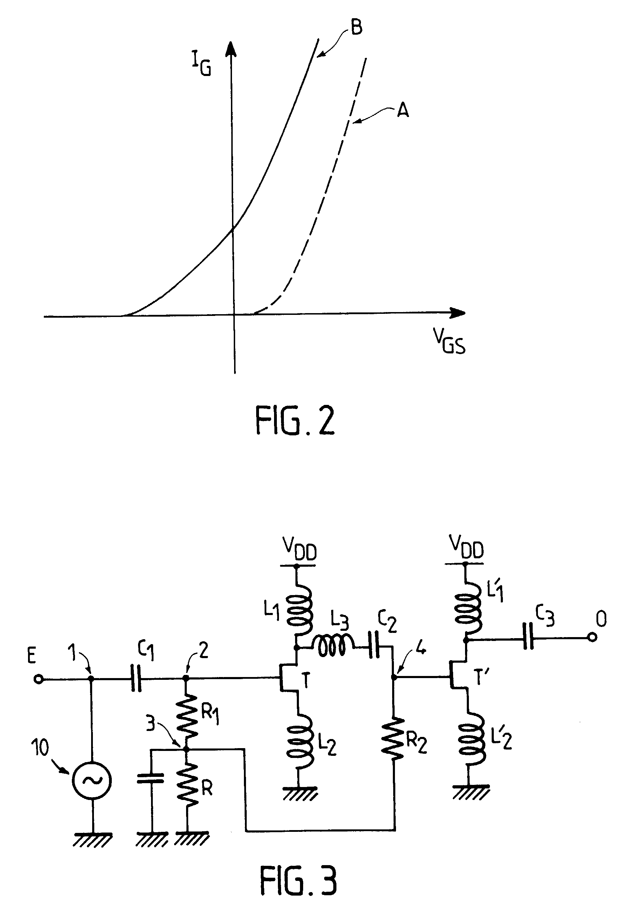

En référence avec la figure 2, est décrit ci-après le fonctionnement des étages montrés sur les figures 1.

La courbe A de la figure 2 en trait discontinu montre la caractéristique $I_G$ en fonction de $V_{GS}$ (courant de grille $I_G$, en fonction de la tension grille-source $V_{GS}$), dans le cas où un tel étage avec le transistor T de puissance, ne reçoit sur sa grille qu'un signal alternatif $V_{IN}$ de faible puissance, ce signal étant appliqué au point E.

Cette courbe montre que, dans ce cas, il n'apparaît pas de courant de fuite dans la grille, c'est-à-dire que le courant de grille $I_G$ est quasiment nul, par exemple de l'ordre du pA. La différence de potentiel aux bornes de la résistance R, disposée entre grille et source, si cette résistance est de l'ordre de 10 kΩ, est de l'ordre de $10^{-7}$V, ce qui est complètement négligeable.

Cependant, en référence avec les figures 1, si on applique au noeud 1, sur la grille G du transistor T, isolée en continu par la capacité $C_1$, un signal alternatif $V_{IN}$ de forte puissance, alors la caractéristique $I_G$ en fonction de $V_{GS}$ devient telle que montrée sur la courbe B de la figure 2, en trait continu. Il apparaît sur la grille G un courant $I_G$ non nul. Quand le signal $V_{IN}$ est fort, à saturation du transistor T, un courant de grille commence à être généré. Plus ce signal $V_{IN}$ est fort, plus le courant de grille $I_G$ est grand. Le courant de grille peut atteindre facilement dans ce cas, une valeur de l'ordre de 10 μA.

Il en résulte qu'aux bornes de la forte résistance R, il apparaît une différence de potentiel négative entre la masse et le point 2 de l'étage montré sur les figures 1a et 1b. Le point 2 est dit "Point de Polarisation" (en anglais BIAS POINT). Si R = 10 kΩ, alors la tension continue négative au point 2 peut être de l'ordre de :

$$V_G = -1 \text{ V}$$

Cette tension négative générée peut alors être prélevée entre le noeud 2 et la masse, et être utilisée pour polariser les grilles des transistors des étages ultérieurs formant un circuit intégré hautes ou hyperfréquences, tel que par exemple celui qui est montré sur la figure 3. Un étage générateur d'une tension $V_G$ de signe opposé à celui de l'alimentation continue $V_{DD}$ sous la compression d'un signal de puissance est appelé ci-après "étage de polarisation générée sous la compression d'un signal de puissance".

La figure 1a illustre un exemple de mise en oeuvre de l'étage de polarisation. Dans le cas de la figure 1a, le signal alternatif $V_{IN}$ de puissance est fourni par un générateur auxiliaire 10 qui fournit ce signal alternatif à une fréquence plus faible, ou faible devant celle du signal de fonctionnement du circuit à polariser, signal de fonctionnement appelé ci-après $V_{RF}$.

Avec ce montage, la fréquence du signal auxiliaire $V_{IN}$ interfère sans apporter d'inconvénients avec celle du signal de fonctionnement dit signal utile $V_{RF}$ appliquée à l'entrée E du circuit. Le signal auxiliaire est ensuite éliminé par filtrage dans un étage de filtrage simple disposé à la suite de l'étage de polarisation générateur de tension négative. Cet étage filtre peut être formé de tout filtre simple connu de l'homme du métier comme approprié à cet effet. Il n'est donc pas décrit plus avant. L'avantage de ce montage à signal $V_{IN}$ auxiliaire est que le signal $V_{RF}$ utile peut avoir n'importe quelle puissance, cette puissance pouvant être faible, constante ou bien variable. Les seules conditions pour obtenir le fonctionnement de l'étage de polarisation sont de disposer d'un transistor T de puissance et d'un signal $V_{IN}$ auxiliaire capable de saturer ce transistor T à une fréquence différente et de préférence plus faible que la fréquence utile du signal utile $V_{RF}$ ; une fréquence plus faible est choisie de préférence parce que plus facile à générer.

La figure 1b illustre un autre exemple, c'est-à-dire une mise en oeuvre différente de l'étage de polarisation. Dans le cas de la figure 1b, le signal alternatif de puissance est constitué par le signal utile $V_{RF}$ lui-même, à la condition qu'il soit capable de saturer le transistor de puissance T. Le signal alternatif $V_{RF}$ à la fréquence utile se retrouve alors parfaitement sur le drain D du transistor T, mais il est affecté d'harmoniques. Ces harmoniques qui sont donc à des fréquences supérieures à la fréquence utile, sont alors facilement éliminées par un filtre simple, dont la structure est choisie parmi toutes structures connues de l'homme du métier comme appropriées à cet effet. Ce filtre n'est donc pas décrit ici.

Dans une variante des circuits décrits en référence avec les figures 1a et 1b, cette variante étant illustrée par la figure 1c, on peut générer une tension continue d'une valeur différente de celle de la tension d'alimentation et d'un niveau plus bas, c'est-à-dire dans ce cas, plus négative.

Le circuit de la figure 1c est pratiquement le même que celui de la figure 1a (et pourrait également fonctionner comme celui de la figure 1b). La différence essentielle introduite en référence avec la figure 1c est que sur la première borne $V_{DD}$, à la place de la tension d'alimentation continue positive, on a maintenant la masse, et, sur la seconde borne $V_{SS}$, à la place de la masse, on a maintenant une tension continue négative par exemple -3V. Le fonctionnement du circuit de la figure 1c étant le même que celui des circuits des figures 1a et 1b, on recueille alors aux bornes de la résistance R une différence de potentiel de -1V, c'est-à-dire que l'on trouve -4V au point 2.

La figure 3 montre un exemple de circuit intégré pouvant favorablement utiliser la tension négative $V_G$ générée par un étage de polarisation selon l'invention, notamment conforme à celui de la figure 1a ou de la figure 1b.

Le circuit de la figure 3 représente deux étages d'un circuit intégré. Le premier étage est un étage de polarisation comprenant un transistor T de puissance dont la source est à la masse à travers une inductance $L_2$, le drain à une tension d'alimentation continue, $V_{DD}$ par exemple, +3V à travers une inductance $L_1$, et dont la grille est polarisée par rapport à la masse à travers une résistance élevée R de par exemple 10 kΩ. Cet étage est muni d'une entrée E sur laquelle est appliqué un signal alternatif $V_{IN}$ capable de saturer ce transistor T de manière telle qu'une tension continue $V_{GS} = -1V$ apparaît aux bornes de la résistance R entre le point 3 et la masse, c'est-à-dire entre grille et source du transistor T, la résistance $R_1$ disposée entre le point 2 et le point 3 étant choisie de faible valeur devant celle de la résistance R.

Cette tension continue de -1V est alors prélevée pour polariser la grille du transistor d'un second étge. Ce second étage comporte un transistor T' dont le drain est polarisé par la tension d'alimentation continue $V_{DD}$ à travers une inductance $L'_1$ et dont la source est à la masse à travers une inductance $L'_2$. La tension de grille du premier transistor T est prélevée au point 3 du premier étage à transistor, et ramenée sur la grille du second étage à transistor au point 4 par une résistance de forte valeur $R_2$.

## Revendications

1. Dispositif comprenant un circuit pour traiter un signal alternatif, ce circuit incluant un premier étage avec un premier élément actif (T) polarisé par une première tension de polarisation ($V_{DD}$) appliquée entre sa première électrode principale (D), et sa seconde électrode principale (S), et par une seconde tension de polarisation ($V_G$) appliquée entre son électrode de commande (G), et sa seconde électrode principale (S), cette électrode de commande (G) recevant aussi le signal alternatif, cet élément actif (T) étant du type dans lequel, en fonctionnement, normalement aucun courant de polarisation ne circule dans l'électrode de commande (G), caractérisé en ce que, la seconde tension de polarisation en continu ($V_G$) est générée aux bornes d'une résistance (R) couplée à l'électrode de commande (G) et à la seconde électrode principale (S), par l'application sur l'électrode de commande (G) d'un signal alternatif de puissance suffisante pour mettre en oeuvre les propriétés rectificatrices de l'élément actif entre son électrode de commande et sa seconde électrode principale.

2. Dispositif selon la revendication 1, caractérisé en ce que le générateur de signal alternatif de puissance pour appliquer sur l'électrode de commande de l'élément actif (T), est le générateur du signal alternatif de fonctionnement lui-même.

3. Dispositif selon la revendication 1, caractérisé en ce que le générateur de signal alternatif de puissance pour appliquer sur l'électrode de commande de l'élément actif (T), est un générateur (10) auxiliaire.

4. Dispositif selon l'une des revendications 2 ou 3, caractérisé en ce que le signal alternatif de puissance est à une fréquence égale ou inférieure à celle du signal alternatif de fonctionnement.

5. Dispositif selon l'une des revendications 1 à 4, caractérisé en ce que le circuit comprend en outre un filtre pour éliminer les signaux transmis par le premier étage du circuit aux fréquences autres que la fréquence utile.

6. Dispositif selon l'une des revendications 1 à 5, caractérisé en ce que la première tension continue appliquée entre les deux électrodes principales (D et S) du premier élément actif est positive, et la tension de polarisation générée ($V_G$) est négative, la première électrode (D) étant positive, et la seconde électrode (S) étant à la masse.

7. Dispositif selon l'une des revendications 1 à 5, caractérisé en ce que la première tension continue appliquée entre les deux électrodes principales (D et S) est négative, et la tension de polarisation générée ($V_G$) est plus négative que la première tension, la première électrode (D) étant à la masse et la seconde électrode (S) étant négative.

8. Dispositif selon l'une des revendications 1 à 7, caractérisé en ce que le signal de fonctionnement est un signal hyperfréquences, en ce que l'élément actif (T) est un transistor de puissance, et en ce que la première tension de polarisation ($V_{DD}$) est appliquée sur ses électrodes principales (D,S) par des inductances (L,L1,L2).

9. Dispositif selon l'une des revendications précédentes, caractérisé en ce que la seconde tension de polarisation générée aux bornes de la résistance (R) est prélevée pour polariser un second élément actif (T') dans un second étage du circuit.

## Patentansprüche

1. Anordnung mit einer Schaltung zum Verarbeiten eines Wechselspannungssignals, wobei diese Schaltung eine erste Stufe mit einem ersten aktiven Element (T) enthält, das mit einer ersten Polarisationsspannung ($V_{DD}$) zwischen seiner ersten Hauptelektrode (D) und seiner zweiten Hauptelektrode (S) polarisiert ist, und mit einer zweiten Polarisationsspannung ($V_G$) zwischen seiner Steuerelektrode (G) und seiner zweiten Hauptelektrode (S) polarisiert ist, wobei diese Steuerelektrode (G) ebenfalls das Wechselspannungssignal empfängt, wobei dieses aktive Element (T) vom Typ ist, in dem im Betrieb normalerweise kein Polarisationsstrom die Steuerelektrode (G) durchfließt, dadurch gekennzeichnet, daß die zweite Gleichspannungspolarisationsspannung ($V_G$) an den Klemmen eines Widerstandes (R) erzeugt wird, der mit der Steuerelektrode (G) und mit der zweiten Hauptelektrode (S) durch Anlegen an die Steuerelektrode (G) eines Wechselspannungssignals gekoppelt ist, das leistungsstark genug ist, um die Gleichrichtereigenschaften des aktiven Elements zwischen seiner Steuerelektrode und seiner zweiten Hauptelektrode zu aktivieren.

**2.** Anordnung nach Anspruch 1, dadurch gekennzeichnet, daß der Generator des Wechselspannungsspeisungssignals, das an die Steuerelektrode des aktiven Elements gelegt werden muß, der Generator selbst des Betriebsfrequenz-Wechselspannungssignals ist.

**3.** Anordnung nach Anspruch 1, dadurch gekennzeichnet, daß der Generator des Wechselspannungsleistungssignals, das an die Steuerelektrode des aktiven Elements (T) gelegt werden muß, ein Hilfsgenerator (10) ist.

**4.** Anordnung nach einem der Ansprüche 2 oder 3, dadurch gekennzeichnet, daß das Leistungswechselspannungssignal eine Frequenz gleich der oder niedriger als die des Betriebsfrequenzwechselspannungssignals ist.

**5.** Anordnung nach einem der Ansprüche 1 bis 4, dadurch gekennzeichnet, daß die Schaltung außerdem ein Filter zum Beseitigen der Signale enthält, die von der ersten Stufe der Schaltung mit Frequenzen anders als der Nutzfrequenz übertragen werden.

**6.** Anordnung nach einem der Ansprüche 1 bis 5, dadurch gekennzeichnet, daß die erste zwischen die zwei Hauptelektroden (D und S) des ersten aktiven Elements gelegte Gleichspannung positiv ist und die erzeugte Polarisationsspannung ($V_G$) negativ ist, wobei die erste Elektrode (D) positiv ist und die zweite Elektrode (S) an Erde liegt.

**7.** Anordnung nach einem der Ansprüche 1 bis 5, dadurch gekennzeichnet, daß die erste zwischen die zwei Hauptelektroden (D und S) gelegte Gleichspannung negativ ist, und die erzeugte Polarisationsspannung ($V_G$) negativer ist als die erste Spannung, wobei die erste Elektrode (D) an Erde liegt und die zweite Elektrode (S) negativ ist.

**8.** Anordnung nach einem der Ansprüche 1 bis 7, dadurch gekennzeichnet, daß das Betriebsfrequenzsignal ein Signal mit sehr hoher Frequenz ist, daß das aktive Element (T) ein Leistungstransistor ist, und daß die erste Polarisationsspannung ($V_{DD}$) an die Hauptelektrode (D, S) über die Induktoren (L, $L_1$, $L_2$) gelegt wird.

**9.** Anordnung nach einem oder mehreren der vorangehenden Ansprüche, dadurch gekennzeichnet, daß die an den Klemmen des Widerstands (R) erzeugte zweite Polarisationsspannung zum Polarisieren eines zweiten aktiven Elements (T') in einer zweiten Schaltungsstufe abgezweigt wird.

**Claims**

**1.** An arrangement comprising a circuit for processing an AC signal which includes a first stage with a first active element (T) biased with a first bias voltage ($V_{DD}$) applied between its first main electrode (D) and its second main electrode (S), and with a second bias voltage ($V_G$) applied between its control electrode (G) and its second main electrode (S), this control electrode (G) also receiving the AC signal, this active element (T) being of the type in which, when in operation, normally no bias current flows in the control electrode (G), characterized in that the second DC bias voltage ($V_G$) is generated at the terminals of a resistor (R) coupled to the control electrode (G) and to the second main electrode (S) by applying to the control electrode (G) an AC signal which is powerful enough to activate the rectifier properties of the active element between its control electrode and its second main electrode.

**2.** An arrangement as claimed in Claim 1, characterized in that the generator of the AC power signal to be applied to the control electrode of the active element (T) is the generator itself of the operating frequency AC signal.

**3.** An arrangement as claimed in Claim 1, characterized in that the generator of the AC power signal to be applied to the control electrode of the active element (T) is an auxiliary generator (10).

**4.** An arrangement as claimed in one of the Claims 2 or 3, characterized in that the AC power signal has a frequency equal to or lower than that of the operating frequency AC signal.

**5.** An arrangement as claimed in one of the Claims 1 to 4, characterized in that the circuit further comprises a filter for eliminating the signals transmitted by the first stage of the circuit with frequencies other than the useful frequency.

**6.** An arrangement as claimed in one of the Claims 1 to 5, characterized in that the first DC voltage supplied between the two main electrodes (D and S) of the first active element is positive, and the generated bias voltage ($V_G$) is negative, the first electrode (D) being positive and the second electrode (S) being connected to ground.

**7.** An arrangement as claimed in one of the Claims 1 to 5, characterized in that the first DC voltage applied between the two main electrodes (D and S) is negative, and the generated bias voltage ($V_G$) is more negative than the first voltage, the first electrode (D) being connected to ground and the second electrode (S) being negative.

8. An arrangement as claimed in one of the Claims 1 to 7, characterized in that the operating frequency signal is a very high frequency signal, in that the active element (T) is a power transistor and in that the first bias voltage ($V_{DD}$) is applied to the main electrodes (D, S) through the inductors (L, $L_1$, $L_2$).

9. An arrangement as claimed in one of the preceding Claims, characterized in that the second bias voltage generated at the terminals of the resistor (R) is tapped for biasing a second active element (T') in a second stage of the circuit.

FIG.1A

FIG.1B

FIG.1C

EP 0 596 562 B1

8

FIG. 2

FIG. 3